# EUROPÄISCHE PATENTSCHRIFT

(11) **EP 2 774 461 B1**
(45) Veröffentlichungstag und Bekanntmachung des Hinweises auf die Patenterteilung: **12.09.2018**
(21) Anmeldenummer: 12787675.3
(22) Anmeldetag: 31.10.2012
(51) Int. Cl.: H05K 3/24, H05K 3/40, H01L 27/01, H05K 3/12, H05K 1/03, H05K 1/09, H05K 1/02

(54) **LEITERPLATTE AUS AIN MIT KUPFERSTRUKTUREN**
CIRCUIT BOARD MADE OF AIN WITH COPPER STRUCTURES
CARTE DE CIRCUIT IMPRIMÉ EN NITRURE D'ALUMINIUM AVEC STRUCTURES EN CUIVRE

(30) Priorität: 03.11.2011 DE 102011117538; 22.06.2012 DE 102012210555; 27.06.2012 DE 102012012692
(43) Veröffentlichungstag der Anmeldung: 10.09.2014
(73) Patentinhaber: CeramTec GmbH, 73207 Plochingen (DE)
(72) Erfinder: DOHN, Alexander, 96117 Memmelsdorf (DE); LENEIS, Roland, 95615 Marktredwitz (DE); HERRMANN, Klaus, 95707 Thiersheim (DE); JÄHNIG, Dietmar, 95463 Bindlach (DE)
(74) Vertreter: Scherzberg, Andreas Hans
(86) Internationale Anmeldenummer: PCT/EP2012/071547
(87) Internationale Veröffentlichungsnummer: WO 2013/064531

(56) Entgegenhaltungen:
- JP-A- 8 181 441
- US-A1- 2003 108 729
- US-A1- 2005 205 293
- US-B2- 7 388 296
- US-B2- 7 825 422

## Beschreibung

Die Erfindung betrifft ein Verfahren zur Herstellung einer keramischen Leiterplatte mit elektrischen Leiterbahnen und Kontaktierungspunkten auf zumindest einer der beiden Seiten und mit zumindest einer Durchkontaktierungs-Bohrung (Via).

US7388296 B2 zeigt glaskeramische Leiterplatten mit Kontaktierungspunkten und Leiterbahnen mit einer Dicke von 35µm.

US7825422 B2 zeigt ein Verfahren zur Herstellung keramischer Leiterplatten mit elektrischen Leiterbahnen und Kontaktierungspunkten auf beiden Seiten, die Durchkontatkierungs-Bohrungen aufweisen. Die Leiterplatten werden für die Montage Licht-emitierender Elemente genutzt.

In JP8181441 A werden glaskeramische Leiterplatten gezeigt, die Leiterbahnen aus kupferhaltigen Leitern umfassen. Dabei kommen 2 verschiedene Pasten zum Einsatz, um eine gute Anhaftung an die Glaskeramik und an das Metall zu gewährleisten.

US2003/108729 A1 beschreibt ein gesintertes Aluminiumnitrid-Substrat, das Vias aufweist und eine interne elektrisch leitfähige Schicht. Es wird zusätzlich ein Verfahren zur Herstellung des Substrats vorgeschlagen.

Der Erfindung liegt die Aufgabe zugrunde, ein Verfahren nach dem Oberbegriff des Anspruchs 1 so zu verbessern, dass die mit dem Verfahren hergestellten Leiterplatten in der LED-Technik für Hochleistungslichtquellen, bei denen viel Wärme entsteht und hohe Ströme fließen, verwendbar sind. Derartige Hochleistungslichtquellen werden zum Beispiel in einem Stadion als Flutlichtanlage verwendet.

Erfindungsgemäß wird diese Aufgabe durch folgende aufeinander folgende Verfahrensschritte gelöst:
a) Herstellung eines Keramiksubstrats aus Aluminiumnitrid und Einbringen der Bohrungen an den für die Vias vorgesehenen Stellen
b) Füllen der Bohrungen mit einer ersten Haftpaste aus Kupfer, Wolfram, Molybdän oder deren Legierungen oder Gemischen hieraus und
c) einmaliges Überdrucken mit einem ersten Siebdruckvorgang zumindest einer Seite des Keramiksubstrats mit dem gewünschten Layout der Leiterbahnen und Kontaktierungspunkte mit einer zweiten Haftpaste
d) optional komplettes oder partielles Wiederholen des Überdruckens mit der zweiten Haftpaste
e) Brennen des bedruckten Keramiksubstrats in einem Einbrennofen mit N2 (Stickstoff), bei dem der Sauerstoffgehalt kontrolliert auf 0 - 50 ppm O₂ gehalten wird
f) Aufdrucken mit einem zweiten Siebdruckvorgang einer glasarmen Deckpaste auf die zweite Haftpaste bis die gewünschte Stärke der Leiterbahnen und Kontaktierungspunkte erreicht ist.
g) Brennen des bedruckten Keramiksubstrats in einem Einbrennofen mit N2 (Stickstoff), bei dem der Sauerstoffgehalt kontrolliert auf 0 - 50 ppm O₂ gehalten wird.

Mit diesem Verfahren lassen sich besonders dicke oder hohe Leiterbahnen herstellen.

Bevorzugt erfolgt nach jedem Siebdruckvorgang ein nachgeschalteter Trocknungsvorgang oder Brennvorgang des Keramiksubstrats. Dies verbessert die Haftung und Langzeitstabilität.

In einer Ausführungsform der Erfindung werden die Leiterbahnen und Kontaktierungspunkte bzw. die eingebrannte Deckpaste mit stromlos Nickel und stromlos Gold korrosionssicher und lötbar verstärkt.

Das Einbringen der Bohrungen an den für die Vias vorgesehenen Stellen erfolgt bevorzugt entweder vor dem Sintern durch Stanzen oder nach dem Sintern durch Laserstrahlung.

In bevorzugter Ausführungsform wird als erste Haftpaste eine hochviskose Kupferpaste verwendet, deren Viskosität zwischen 800 Pa*s und 1.200 Pa*s, bevorzugt zwischen 900 Pa*s und 1.100 Pa*s und besonders bevorzugt bei 1.000 Pa*s liegt.

Die Kupferpaste enthält bevorzugt CuO oder Cu₂O und ein für AlN geeignetes Haftglas, vorzugsweise aus ZnO-SiO2.

In einer Ausführungsform sind bevorzugt in der Kupferpaste volumenvergrössernde Bestandteile wie Al oder Ti und in der Hitze kupferabgebende Substanzen wie CuCl enthalten.

Bevorzugt ist die zweite Haftpaste mit der ersten Haftpaste bis auf deren Viskosität identisch, wobei die Viskosität der zweiten Haftpaste um die Hälfte geringer ist als die der ersten Haftpaste. Mit "um die Hälfte" ist bevorzugt 50 % +- 10 % gemeint, besonders bevorzugt 50 % +- 5 % und ganz besonders bevorzugt 50 % +- 2 % gemeint.

Die Viskosität der zweiten Haftpaste beträgt bevorzugt 500 Pa*s. Mit bevorzugt 500 Pa*s wird eine Viskosität zwischen 500 +- 50 Pa*s verstanden, besonders bevorzugt zwischen 500 +- 10 Pa*s.

In einer Ausführungsform der Erfindung ist die Deckpaste mit der Haftpaste bis auf das Fehlen des Haftglases identisch, weist jedoch eine niedrigere Viskosität als die Haftpaste auf, wobei die Viskosität der Deckpaste zwischen 1/3 und 2/3 der Viskosität der Haftpaste und besonders bevorzugt bei 40-60% der Viskosität der Haftpaste liegt.

Bevorzugt wird beim Wiederholen des Überdruckens der Leiterbahnen und Kontaktierungspunkte der Überdruck 0,01 - 0,05 mm umlaufend kleiner ausgeführt.

Bei einer keramischen Leiterplatte mit Leiterbahnen und Kontaktierungspunkten, hergestellt nach dem eben beschriebenen Verfahren beträgt die vertikale Dicke oder Höhe der Leiterbahnen und Kontaktierungspunkte bevorzugt zwischen 20 und 125 µm, vorzugsweise 60 bis 90 µm.

Erfindungsgemäß sind die Vias mit Kupfer, Wolfram oder Molybdän oder Gemischen hieraus gefüllt. Silber geht wegen zu heftiger Legierungs-Reaktion nicht.

Bevorzugt werden diese Leiterplatten in der LED-Technik für Hochleistungslichtquellen verwendet, bei denen viel Wärme entsteht und hohe Ströme fließen. Derartige Hochleistungslichtquellen werden zum Beispiel in einem Stadion als Flutlichtanlage verwendet.

Herstellverfahren:
1) Zur Herstellung wird ein Keramiksubstrat aus Aluminiumnitrid verwendet, welches zum Einbrigen der Vias an deren Stellen entweder vor dem Sintern gestanzt oder nach dem Sintern mit Laserstrahlung lasergebohrt wird.
2) Erfindungsgemäß werden als erster Schritt die Vias mit einer Haftpaste aus Kupfer, Wolfram oder Molybdän oder deren Legierungen oder Mischungen gefüllt. Bevorzugt wird als Haftpaste eine Kupferpaste mit einer Viskosität von 1.000 Pa*s verwendet. Die Kupferviapaste kann CuO oder Cu₂O enthalten und ein für AlN geeignetes Haftglas, vorzugsweise aus ZnO-SiO₂. Zusätzlich sind volumenvergrößernde Bestandteile wie Al oder Ti und in der Hitze kupferabgebende Substanzen wie CuCl günstig.
3) Anschließend wird zumindest eine Seite des Keramiksubstrats gemäß gewünschtem Layout der Leiterbahnen und Kontaktierungspunkte mit der unter Ziffer 2 genannten Kupferpaste einmal mit einem Siebdruckvorgang komplett überdruckt.
4) Sollen besonders dicke Leiterbahnen und Kontaktierungspunkte hergestellt werden, wird zusätzlich ein weiterer Siebdruckvorgang mit der genannten Kupferpaste als Haftpaste ausgeführt. Die Kupferpaste kann komplett oder partiell mehrmals mit einem Siebdruckvorgang überdruckt werden.
5) Anschließend wird das Keramiksubstrat mit der oder den aufgedruckten Haftpasten bei bevorzugt 80°C getrocknet.
6) Anschließend wird das bedruckte Keramiksubstrat bei 900°C durch einen Einbrennofen mit N2 (Stickstoff) gefahren, bei dem der Sauerstoffgehalt kontrolliert auf 0 - 50 ppm O₂ gehalten wird.
7) Anschließend wird auf die eingebrannte Haftpaste eine glasarme Deckpaste in geeigneter Viskosität und geeigneter Zusammensetzung aufgedruckt, bis die oben genannte Kupferstärke der Leiterbahnen und Kontaktierungspunkte erreicht ist. Die Deckpaste ist mit der Haftpaste bis auf das Fehlen des Haftglases identisch, hat jedoch eine niedrigere Viskosität als die Haftpaste. Bevorzugt liegt die Viskosität der Deckpaste zwischen 1/3 und 2/3 der Viskosität der Haftpaste und besonders bevorzugt bei 40-60% der Viskosität der Haftpaste.
8) Anschließend wird das Keramiksubstrat mit der aufgedruckten Deckpaste bei bevorzugt 80°C getrocknet.
9) Anschließend wird das bedruckte Keramiksubstrat bei 900°C durch einen Einbrennofen mit N2 (Stickstoff) gefahren, bei dem der Sauerstoffgehalt kontrolliert auf 0 - 50 ppm O₂ gehalten wird.
10) Alternativ entfällt Ziffer 6 und die Deckpaste wird gleich nach dem Trocknen ohne vorherigem Einbrennvorgang auf die Haftpaste aufgedruckt.

Erfindungsgemäß werden die Leiterbahnen und Kontaktierungspunkte bevorzugt aus Kupfer oder einer Kupferlegierung mit mindestens einem Siebdruckvorgang mit einer Kupferpaste auf das Keramiksubstrat aus Aluminiumnitrid aufgebracht, wodurch die oben genannte Kupferstärke erzielt wird. Das einmalige Aufbringen reicht bei einer Dicke oder Höhe der Leiterbahnen und Kontaktierungspunkte zwischen 20 und 40 µm aus. Wenn dickere oder höhere Leiterbahnen und Kontaktierungspunkte von 40 bis 125 µm erforderlich sind, werden bevorzugt zwei oder auch mehr Siebdruckvorgänge durchgeführt. Üblicherweise arbeitet man mit 2 unterschiedlichen Pasten, nämlich einer Haftpaste direkt auf dem Keramiksubstrat und einer Deckpaste auf der Haftpaste. Erfindungsgemäß werden beide Pasten ausschließlich mit einem Siebdruckvorgang aufgebracht.

Beim Herstellvorgang werden die Vias im Keramiksubstrat mit einer Haftpaste gefüllt und zumindest eine Seite des Keramiksubstrats gemäß gewünschtem Layout mit der Haftpaste ein- oder zweimal komplett überdruckt. Die Haftpaste kann zusätzlich noch mit einem weiteren Siebdruckvorgang überdruckt werden. Nach jedem Aufbringen wird bevorzugt getrocknet. Anschließend wird auf die Haftpaste eine Deckpaste in geeigneter Viskosität und geeigneter Zusammensetzung aufgedruckt, bis die oben genannte Kupferstärke der Leiterbahnen und Kontaktierungspunkte erreicht ist.

Auch die andere Seite der Leiterplatte, d.h. die Unterseite kann eine oder mehrere Überdrucke mit Kupferpaste enthalten.

Die Vias haben bevorzugt einen Durchmesser von 0,20 mm, können jedoch je nach Dicke des Keramiksubstrats einen angepassten Durchmesser haben. Dickere Keramiksubstrate brauchen weitere Vias, d. h. Vias mit einem größeren Durchmesser. Für 1 mm Dicke des Keramiksubstrats ist ein Durchmesser der Vias von 0,3 - 0,4 mm erforderlich. Die Vias werden bevorzugt mit einer hochviskosen Kupferpaste mit einer Viskosität von 1.000 Pa*s auf einer Siebdruckmaschine mit passendem Sieblayout und einer Druckplatte im Layout der Vias gefüllt. Die Kupferpaste (besonders die Haftpaste direkt auf dem AlN-Substrat) enthält CuO oder Cu₂O und ein für AlN geeignetes Haftglas (wie vorzugsweise) aus ZnO-SiO₂. Dies ist der erste Siebdruckvorgang. Anschließend wird bevorzugt das bedruckte Substrat bei bevorzugt 80°C getrocknet.

Anschließend wird mit der gleichen Kupferpaste, aber verdünnt auf bevorzugt 500 Pa*s ein weiterer Siebdruckvorgang mit demselben Layout auf der Siebdruckmaschine ausgeführt. Dies ist der zweite Siebdruckvorgang. Der zweite Siebdruckvorgang erfolgt genau auf die durch den ersten Siebdruckvorgang erzeugten Leiterbahnen und Kontaktierungspunkte, so dass deren Dicke oder Höhe zunimmt.

Das so vorbereitete Substrat wird bei 900°C durch einen Einbrennofen mit N₂ (Stickstoff) gefahren, bei dem der Sauerstoffgehalt kontrolliert auf 0 - 50 ppm O₂ gehalten wird. Das Kupfer berührt nirgendwo das Brennhilfsmittel. Danach werden bestimmte Bereiche oder Strukturen oder die gesamte bereits bedruckte und eingebrannte Struktur einseitig oder beidseitig mit Hilfe einer weiteren glasarmen Kupferpaste verstärkt. Es wird erneut mit gleichen Bedingungen eingebrannt. Die Stärke der Kupferschicht liegt jetzt in der erfindungsgemäßen Stärke oder Dicke vor.

Die Deckschicht bzw. eingebrannte Kupferschicht wird anschließend bevorzugt mit 4 µm stromlos Nickel, wahlweise 0,05 µm Pd und 0,05 µm stromlos Gold korrosionssicher und lötbar verstärkt. Die Metallisierung, d.h. die Kupferschicht schließt so dicht an die Keramik an, dass auch die Vias keine Lecks haben, durch die beispielsweise dünnflüssige Kleber auf die obere LED-Seite dringen können.

Das mit Siebdruck bedruckte Keramiksubstrat wird entweder nach jedem einzelnen Druckvorgang oder nach allen Druckvorgängen gemeinsam bei geeigneter Temperatur, üblicherweise für 6-10 min bei 900°C, und Stickstoffatmosphäre mit sehr geringem Restsauerstoff von vorzugsweise 0 - 50 ppm, eingebrannt.

Die Erfindung schließt für das AIN die Lücke zwischen der bekannten DCB-Technik (ab 200 µm) und der Dickfilmtechnik (bis etwa 20 µm), und kann gefüllte Vias der Dickfilmtechnik verwenden, wodurch Kontaktierungen zu beiden Seiten möglich werden.

Nachfolgend ein konkretes Beispiel :
Ein gesintertes keramisches Substrat aus AlN der Grösse 114*114 * 0,38 mm wird mit einem definierten Layout lasergebohrt. Die Vias haben einen Durchmesser von 0,20 mm. Die Vias werden mit einer hochviskosen Kupferpaste 1.000 Pa*s auf einer Siebdruckmaschine mit passendem Sieblayout und einer Druckplatte im Layout der Vias gefüllt. Die Kupferpaste enthält CuO und/oder Cu₂O, ein für AlN geeignetes Haftglas aus ZnO-SiO₂ und 2% Al-Pulver sowie eine kleine Menge von 3% CuCl. Nach Trocknen bei 80°C wird mit der gleichen Paste, aber verdünnt auf 500 Pa*s auf jeder Seite des Substrats ein Flächendruck auf der Siebdruckmaschine ausgeführt. Das so vorbereitete Substrat wird bei 900°C durch einen Einbrennofen mit N₂ gefahren, bei dem der Sauerstoffgehalt kontrolliert auf 0 - 50 ppm O₂ gehalten wird. Das Kupfer berührt nirgendwo das Brennhilfsmittel. Danach werden bestimmte Strukturen oder die gesamte bereits gedruckte und eingebrannte Struktur einseitig oder beidseitig mit Hilfe einer weiteren glasarmen Kupferpaste verstärkt. Es wird erneut mit gleichen Bedingungen eingebrannt. Die Stärke der Kupferschicht liegt jetzt bei 70 µm. Die Kupferschicht wird mit 4 µm stromlos Nickel und 0,05 µm stromlos Gold korrosionssicher und lötbar verstärkt. Die Metallisierung schließt so dicht an die Keramik an, dass auch die Vias keine Lecks haben, durch die beispielsweise dünnflüssige Kleber auf die obere LED-Seite dringen können.

Merkmale von Ausführungsformen der Erfindung:
- keramische Leiterplatte aus Aluminiumnitrid mit eingebrannten Leiterbahnen und Kontaktierungspunkten aus Kupfer oder einer Kupferlegierung, wobei die Dicke oder Höhe oder Kupferstärke der Leiterbahnen und Kontaktierungspunkte zwischen 20 und 500 µm, bevorzugt 20 bis 125 µm, besonders bevorzugt 60-90 µm liegt.
- Auf der Leiterplatte sind Vias angeordnet, die mit Kupfer, Wolfram oder Molybdän gefüllt sind.
- Zur Herstellung wird ein Keramiksubstrat aus Aluminiumnitrid verwendet, welches zum Einbrigen der Vias an deren Stellen entweder vor dem Sintern gestanzt oder nach dem Sintern mit Laserstrahlung lasergebohrt wird.
- die Leiterbahnen und Kontaktierungspunkte werden auf ein Keramiksubstrat mit mindestens zwei Siebdruckvorgängen und Einbrennvorgängen mit Kupfer oder einer Kupferlegierung aufgebracht.
- Es werden zwei Pasten verwendet und eingebrannt. Die direkt an das Keramiksubstrat angrenzende bzw. aufliegende Paste ist eine Haftpaste mit einem Glasanteil und die sich darauf befindliche Deckpaste ist glasarm ausgeführt, da die Leiterbahnen und Kontaktierungspunkte galvanikfähig sein sollen.
- Es wird bei beiden Siebdruckvorgängen exakt dasselbe Siebdruck-Layout verwendet. Wenn jedoch an einigen Stellen keine dicke Leiterbahn oder kein dicker Kontaktierungspunkt benötigt wird, so kann der zweite Siebdruckvorgang diese Stelle oder diese Stellen aussparen.
- Bevorzugt wird der zweite Aufdruck mit etwa 0,01 - 0,05 mm umlaufend kleiner ausgeführt, damit die zweite Paste nicht an den "Hängen" der ersten Schicht herunterläuft und die Strukturen unkontrolliert verbreitert.
- Beim ersten Siebdruckvorgang wird eine hochviskose Kupferpaste als Haftpaste verwendet, deren Viskosität zwischen 800 Pa*s und 1.200 Pa*s liegt. Bevorzugt liegt diese zwischen 900 Pa*s und 1.100 Pa*s und besonders bevorzugt bei 1.000 Pa*s.
- Bei der Deckpaste ist die Viskosität niedriger als bei der Haftpaste, um die Oberfläche glatter zu machen und den Siebgewebeabdruck gering zu halten. Die Deckpaste hat bevorzugt eine Viskosität, die niedriger als die Viskosität der Haftpaste ist. Bevorzugt liegt die Viskosität zwischen 1/3 und 2/3 der Viskosität der Haftpaste und besonders bevorzugt bei 40-60% der Viskosität der Haftpaste. Die Haft- und die Deckpaste sind jedoch chemisch identisch und unterscheiden sich, abgesehen vom Glasanteil nur in ihrer Viskosität.
- Die Kupferpaste der Haftpaste enthält CuO und/oder Cu₂O und ein für AlN geeignetes Haftglas aus ZnO-SiO₂.
- Nach dem ersten Siebdruckvorgang wird das Keramiksubstrat getrocknet bei geeigneten Temperaturen, bevorzugt 80 °C.
- Das Keramiksubstrat aus AlN hat eine Größe von bevorzugt 114*114 * 0,38 mm. 0,38 mm ist die Dicke des Keramiksubstrats.
- Das Einbrennen erfolgt bevorzugt bei 900 °C in einem Einbrennofen mit N₂ (Stickstoff), bei dem der Sauerstoffgehalt kontrolliert auf 6-10 ppm O₂ gehalten wird.
- Im Einbrennofen berührt das Kupfer nirgendwo das Brennhilfsmittel.

## Patentansprüche

1. Verfahren zur Herstellung einer keramischen Leiterplatte mit elektrischen Leiterbahnen und Kontaktierungspunkten auf zumindest einer der beiden Seiten und mit zumindest einer Durchkontaktierungs-Bohrung (Via), mit folgenden aufeinander folgenden Verfahrensschritten:
a) Herstellung eines Keramiksubstrats aus Aluminiumnitrid und Einbringen der Bohrungen an den für die Vias vorgesehenen Stellen,
b) Füllen der Bohrungen mit einer ersten Haftpaste aus Kupfer, Wolfram, Molybdän oder deren Legierungen oder Gemischen hieraus und
c) einmaliges Überdrucken mit einem ersten Siebdruckvorgang zumindest einer Seite des Keramiksubstrats mit dem gewünschten Layout der Leiterbahnen und Kontaktierungspunkte mit einer zweiten Haftpaste,
d) optional komplettes oder partielles Wiederholen des Überdruckens mit der zweiten Haftpaste,
e) Brennen des bedruckten Keramiksubstrats in einem Einbrennofen mit N₂ (Stickstoff), bei dem der Sauerstoffgehalt kontrolliert auf 0 - 50 ppm O₂ gehalten wird,
f) Aufdrucken mit einem zweiten Siebdruckvorgang einer glasarmen Deckpaste auf die zweite Haftpaste bis die gewünschte Stärke der Leiterbahnen und Kontaktierungspunkte erreicht ist,
g) Brennen des bedruckten Keramiksubstrats in einem Einbrennofen mit N₂ (Stickstoff), bei dem der Sauerstoffgehalt kontrolliert auf 0 - 50 ppm O₂ gehalten wird, und wobei
h) als erste Haftpaste eine hochviskose Kupferpaste verwendet wird, deren Viskosität zwischen 800 Pa*s und 1.200 Pa*s, bevorzugt zwischen 900 Pa*s und 1.100 Pa*s und besonders bevorzugt bei 1.000 Pa*s liegt,
i) die Kupferpaste CuO oder Cu₂O und ein für AlN geeignetes Haftglas aus ZnO-SiO₂ enthält und
j) die zweite Haftpaste mit der ersten Haftpaste bis auf deren Viskosität identisch ist, wobei die Viskosität der zweiten Haftpaste um die Hälfte geringer ist als die der ersten Haftpaste.

2. Verfahren nach Anspruch 1, **dadurch gekennzeichnet, dass** nach jedem Siebdruckvorgang ein nachgeschalteter Trocknungsvorgang oder Brennvorgang des Keramiksubstrats erfolgt.

3. Verfahren nach Anspruch 1 oder 2, **dadurch gekennzeichnet, dass** die Leiterbahnen und Kontaktierungspunkte bzw. die eingebrannte Deckpaste mit stromlos Nickel und stromlos Gold verstärkt wird.

4. Verfahren nach einem der Ansprüche 1 bis 3, **dadurch gekennzeichnet, dass** das Einbringen der Bohrungen an den für die Vias vorgesehenen Stellen vor dem Sintern durch Stanzen oder nach dem Sintern durch Laserstrahlung erfolgt.

5. Verfahren nach einem der Ansprüche 1 bis 4, **dadurch gekennzeichnet, dass** in der Kupferpaste volumenvergrössernde Bestandteile, nämlich Al oder Ti und in der Hitze kupferabgebende Substanzen, nämlich CuCl enthalten sind.

6. Verfahren nach einem der Ansprüche 1 bis 5, **dadurch gekennzeichnet, dass** die Viskosität der zweiten Haftpaste 500 Pa*s beträgt.

7. Verfahren nach einem der vorhergehenden Ansprüche, **dadurch gekennzeichnet, dass** beim Wiederholen des Überdruckens der Leiterbahnen und Kontaktierungspunkte der Überdruck 0,01 - 0,05 mm umlaufend kleiner ausgeführt wird.

## Claims

1. A method for producing a ceramic circuit board having electric printed conductors and contact points on at least one of the two sides and having at least one through-hole contact (via) with the following sequential method steps:
a) production of a ceramic substrate of aluminium nitride and introduction of the bore holes at the locations provided for the vias,
b) filling of the bore holes with a first adhesive paste of copper, tungsten, molybdenum or their alloys or mixtures thereof, and
c) one-pass overprinting, with a first screen printing process, of at least one side of the ceramic substrate with the desired layout of the printed conductors and contact points with a second adhesive paste,
d) optionally complete or partial repetition of the overprinting with the second adhesive paste,
e) firing of the printed ceramic substrate in a firing oven with N₂ (nitrogen), during which the oxygen content is held in a controlled manner at 0 to 50 ppm O₂,
f) printing, with a second screen printing process, of a cover paste with a low glass content onto the second adhesive paste until the desired thickness of the printed conductors and contact points is achieved,
g) firing of the printed ceramic substrate in a firing oven with N₂ (nitrogen), during which the oxygen content is held in a controlled manner at 0 to 50 ppm O₂, and wherein
h) a highly viscous copper paste is used as the first adhesive paste, the viscosity of which lies between 800 Pa·s and 1200 Pa·s, preferably between 900 Pa·s and 1100 Pa·s and particularly preferably at 1000 Pa·s,
i) the copper paste contains CuO or Cu₂O and an adhesive glass of ZnO-SiO₂ suitable for AlN, and
j) the second adhesive paste is identical with the first adhesive paste except for its viscosity, wherein the viscosity of the second adhesive paste is lower by half than that of the first adhesive paste.

2. A method according to claim 1, **characterised in that** a downstream process of drying or process of firing of the ceramic substrate is effected after each screen printing process.

3. A method according to claim 1 or 2, **characterised in that** the printed conductors and contact points or the fired cover paste are/is reinforced with nickel currentlessly and gold currentlessly.

4. A method according to one of claims 1 to 3, **characterised in that** the introduction of the bore holes at the locations provided for the vias is effected by punching prior to sintering or by laser radiation after sintering.

5. A method according to one of claims 1 to 4, **characterised in that** volume-increasing constituents, namely Al or Ti, and substances that release copper in the heat, namely CuCl, are contained in the copper paste.

6. A method according to one of claims 1 to 5, **characterised in that** the viscosity of the second adhesive paste amounts to 500 Pa·s.

7. A method according to one of the preceding claims, **characterised in that** in the event of repetition of the overprinting of the printed conductors and contact points the overprinting carried out is all round 0.01 - 0.05 mm smaller.

## Revendications

1. Procédé de fabrication d'une plaque de conducteurs en céramique, comportant des bandes de conducteur électrique et des points de contact électrique sur au moins l'une de ses deux faces, et comportant au moins une via (perforation de contact), lequel procédé comprend les étapes successives suivantes :
a) préparer un substrat en céramique à partir de nitrure d'aluminium, et y percer des trous aux points prévus pour les vias,
b) remplir ces trous avec une première pâte adhésive à base de cuivre, de tungstène, de molybdène ou d'un de leurs alliages ou mélanges,
c) par une première opération de sérigraphie, faire sur au moins l'une des faces du substrat en céramique une impression unique avec une deuxième pâte adhésive selon le schéma voulu des bandes conductrices et des points de contact,
d) en option, réitérer complètement ou partiellement l'impression avec la deuxième pâte adhésive,
e) faire cuire le substrat en céramique imprimé dans un four de cuisson sous atmosphère d'azote, dont la teneur en oxygène est régulée de manière à être maintenue à une valeur de 0 à 50 ppm,
f) par une deuxième opération de sérigraphie, faire avec une pâte de couverture pauvre en verre une impression par-dessus la deuxième pâte adhésive, jusqu'à atteindre l'épaisseur voulue pour les bandes conductrices et les points de contact,
g) et faire cuire le substrat en céramique imprimé dans un four de cuisson sous atmosphère d'azote, dont la teneur en oxygène est régulée de manière à être maintenue à une valeur de 0 à 50 ppm, étant entendu
h) qu'on utilise comme première pâte adhésive une pâte au cuivre fortement visqueuse, dont la viscosité vaut entre 800 et 1200 Pa.s, de préférence entre 900 et 1100 Pa.s et mieux encore 1000 Pa.s,
i) que cette pâte au cuivre contient de l'oxyde cuivrique (CuO) ou de l'oxyde cuivreux (Cu₂O), et un verre adhésif approprié pour nitrure d'aluminium,
j) et que la deuxième pâte adhésive est identique à la première pâte adhésive, à ceci près que la viscosité de la deuxième pâte adhésive est de moitié plus faible que celle de la première pâte adhésive.

2. Procédé conforme à la revendication 1, **caractérisé en ce que** chaque opération de sérigraphie est suivie d'une opération intercalée de séchage ou de cuisson du substrat en céramique.

3. Procédé conforme à la revendication 1 ou 2, **caractérisé en ce que** les bandes conductrices et les points de contact, ou la pâte de couverture cuite, sont renforcés avec du nickel chimique et de l'or chimique.

4. Procédé conforme à l'une des revendications 1 à 3, **caractérisé en ce que** le percement des trous aux points prévus pour les vias est réalisé avant le frittage, par poinçonnage, ou après le frittage, au moyen d'un rayon laser.

5. Procédé conforme à l'une des revendications 1 à 4, **caractérisé en ce que** la pâte au cuivre contient des composants qui en font augmenter le volume, à savoir de l'aluminium ou du titane, et des corps qui, à chaud, libèrent du cuivre, à savoir du chlorure cuivreux (CuCl).

6. Procédé conforme à l'une des revendications 1 à 5, **caractérisé en ce que** la viscosité de la deuxième pâte adhésive vaut 500 Pa.s.

7. Procédé conforme à l'une des revendications précédentes, **caractérisé en ce que**, lors de la réitération de l'impression des bandes conductrices et des points de contact, l'impression est réalisée circonférentiellement plus petite de 0,01 à 0,05 mm.
